# EUROPEAN PATENT SPECIFICATION

(11) **EP 0 881 867 B1**
(45) Date of publication and mention of the grant of the patent: **04.04.2001**
(21) Application number: 98303937.1
(22) Date of filing: 19.05.1998
(51) Int. Cl.: H05K 5/02

(54) **Rugged housing for portable devices**
Stabiles Gehäuse für tragbare Vorrichtungen
Boîtier stable pour les dispositifs portatifs

(30) Priority: 30.05.1997 US 866754
(43) Date of publication of application: 02.12.1998
(73) Proprietor: Lucent Technologies Inc., Murray Hill, New Jersey 07974-0636 (US)
(72) Inventor: Goyal, Suresh, Warren, New Jersey 07928 (US); Patel, Dhirendra Manubhai, Jersey City, New Jersey 07302 (US); Kasbekar, Pratod Vishweshwar, Manalapan, New Jersey 07726 (US); Upasani, Sanjay Sudhaker, Manalapan, New Jersey 07726 (US)
(74) Representative: Johnston, Kenneth Graham

(56) References cited:
- EP-A2- 0 408 985
- US-A- 4 445 008
- US-A- 4 641 762
- US-A- 5 475 566

## Description

### Technical Field

This invention relates to housing design, and in particular, to housings for portable electronic devices.

### Background of the Invention

There is a trend in the art of portable electronic devices, such as telephones, pagers, electronic organizers, calculators, hand-held video games, remote controls, computers and the like, to make them smaller, lighter, and cheaper. As a result, thinner and lighter plastic is being used for the housing, making the housing more likely to bend and warp when subjected to the resulting bending and torsional forces upon being dropped.

Associated with such portable devices is a design philosophy, namely, that there cannot be any visible screws. This is to discourage the user from opening the device. As a result, the screws are typically located under the battery, so that they are not visible. Additionally, because the insertion of screws requires time and incurs labor costs, there is a desire to reduce the number of screws that are employed. In fact there are designs in the market, or being readied for the market, that use only a single screw.

Because of the small size of the devices, it is desired to maximize the available space for electronic circuitry, and so large engaging elements are undesirable. However, there remains a need that the halves of the housing be controllably separable, e.g., disassembled, so that repairs or testing may be performed on the components that are contained therein.

US-A-5475566 described a non-portable, but movable, device with a a clamshell housing formed from two halves. There is disclosed a fastening arrangement and engaging parts.

We have recognized that the design philosophy of such portable devices prevents placing screws in each of the comers of the device as well as in the middle along the longest side edges. As a result, when a portable device is dropped, there is a tendency to have substantial relative motion, i.e., slip, between the two halves of a clamshell type housing along the interface where they meet. If this occurs, there is a likelihood that the housing, or a portion thereof, will pop open, i.e., gaps will occur at the interface. This is true even when there are hooks and matching receptacles molded into the halves of the housing to keep the halves together, because the resulting bending and/or torsion causes the hooks to disengage. Moreover, in such devices, the battery tends to supply a reinforcement of the devices housing. However, upon the dropping of such devices, the battery tends to disengage, allowing the housing an even greater opportunity to flex.

Therefore, in accordance with the principles of the invention as defined in claim 1, engaging elements other than screws or hooks are employed to prevent the two halves of a clamshell housing from having significant slipping between them along the interface at which they meet when the clamshell is subjected to bending and/or torsional moments. Such engaging elements may include slip preventing elements at the clamshell halves interface, e.g., various forms of interlocking teeth, elements that increase friction, or the like, which are added to, or molded into, each half of the housing. By restricting relative motion along the plane of the interface, the propensity to separate along the direction perpendicular to the interface plane is reduced. This is achieved because the restriction of the relative motion increases the bending and torsional rigidities.

According to one aspect of the present invention, there is provided a portable device having a clamshell housing made of two halves, said halves being controllably separable, wherein said halves are coupled together by a method other than having a screw located substantially in each corner of said portable device, comprising: a fastener for coupling each of said two halves of said clamshell housing one to the other to form said clamshell; at least one engaging element other than screws or hooks, said engaging element being arranged so as to prevent said two halves of said clamshell housing from having substantial relative motion between them at an interface at which they meet when said two halves of said clamshell housing bend and/or twist. The engaging element can include a tooth, a snap, or a post. It can assert a force normal to said interface.

According to another aspect of the present invention there is provided a clamshell housing for use in a portable device, said clamshell housing comprising: at least two portions, said portions being controllably separable; a fastening system for providing primary coupling of each of said at least two portions of said clamshell housing to the other to form some of said clamshell housing, said coupling system employing a coupling method other than having a screw located substantially at each of a majority of any corners of said clamshell housing; and at least one engaging element other than screws or hooks, said engaging element being arranged to restrict at least torsion and/or bending of said clamshell housing which results in a separation of said portions of said clamshell housing from each other at the interface at which they meet. The engaging element can provide an interlocking force normal to an interface between said at least two portions of said clamshell housing coupled by said fastening system.

According to a further aspect of the present invention, there is provided a section of a clamshell housing portion, said clamshell housing being assembled from at least two portions and being for use in a portable device, said clamshell housing further having a fastening system for providing primary coupling of each of said at least two portions of said clamshell housing to the other to form some of said clamshell housing, said coupling system employing a coupling method other than having a screw located substantially at each of a majority of any corners of said clamshell housing, said portions of said housing being controllably separable, said section being characterized by at least one engaging element other than screws or hooks, said engaging element being arranged to restrict at least torsion and/or bending of said clamshell housing which results in a separation of said portions of said clamshell housing from each other at the interface at which they meet when coupled by said fastening system. The section can be a majority section. The engaging element can be a tooth, said tooth being adapted to engage an element of the opposing clamshell housing portion. The element of the opposing clamshell housing portion can abut against said tooth when said clamshell housing undergoes torsional and/or bending force. The element of the opposing clamshell housing portion can be a wall used for forming a structure selected from the set consisting of a recess, a slot or a post. A dimension of said element of the opposing clamshell housing portion can substantially correspond in size to said tooth. The engaging element can provide an interlocking force normal to an interface between said two at least two portions of said clamshell housing coupled by said fastening system.

According to a still further aspect of the present invention, there is provided a section of a clamshell housing portion, said clamshell housing being assembled from at least two portions and being for use in a portable device, said clamshell housing further having a fastening system for providing primary coupling of each of said at least two portions of said clamshell housing to the other to form some of said clamshell, said coupling system employing a coupling method other than having a screw located substantially at each of a majority of any corners of said clamshell housing, said portions of said housing being controllably separable, said section being characterized by at least one tooth protruding beyond an average line of interface between said section of said clamshell housing portion and its opposing portion of said housing, said tooth being adapted to engage a matching recess in an opposing portion of said clamshell housing whereby torsion and/or bending strength of said clamshell housing is increased when said portions are coupled together to form said housing. The section can be a majority section. The tooth can be located at a furthest effective distance from a section of bending and/or torsional weakness about which maximum bending and/or torsion of said housing is likely to occur when a torsional and/or bending force is applied to said housing. At least some of said section of said clamshell housing portion can have a double wall, and said tooth can protrude from between each wall of said double wall. The tooth can protrude from one side of a wall of said section of said clamshell housing portion so that said tooth is not visible from an exterior side of said wall of said section of said clamshell housing portion when said at least two portions of said clamshell housing are coupled together. The wall of said section of said clamshell housing portion can have a step molded therein. The matching recess can be formed by two ribs extending interiorly from said opposing portion of said housing. The tooth can be small in size so as to resemble a post, and/or the tooth can provide an interlocking force normal to said interface between said section of said clamshell housing portion and its opposing portion of said housing. The tooth can be a snap.

According to a still further aspect of the present invention, there is provided a section of a clamshell housing portion, said clamshell housing being assembled from at least two portions and being for use in a portable device, said clamshell housing further having a fastening system for providing primary coupling of each of said at least two portions of said clamshell housing to the other to form some of said clamshell, said coupling system employing a coupling method other than having a screw located substantially at each of a majority of any corners of said clamshell housing, said portions of said housing being controllably separable, said section being characterized by at least one receptacle for said tooth which is recessed below an average line of interface between said section of said clamshell housing portion and its opposing portion of said housing, said recess being adapted to engage a matching tooth in an opposing portion of said clamshell housing whereby torsion and/or bending strength of said clamshell housing is increased when said portions are coupled together to form said housing. The section is a majority section, and/or the receptacle can be a recess. Some of said section can have a double wall construction made up of an inner and an outer wall, and said receptacle can be between said inner and said outer wall. The receptacle can be formed by a gap between two posts.

According to a still further aspect of the invention there is provided a clamshell housing for use in a portable device, said clamshell housing comprising: at least two portions, said portions being controllably separable; and a fastening system for providing primary coupling of each of said at least two portions of said clamshell housing to the other to form some of said clamshell, said coupling system employing a coupling method other than having a screw located substantially at each of a majority of any corners of said clamshell housing; wherein a first of said at least two portions includes at least first and second teeth which protrude beyond a local interface line at which said first portion meets said second portion, said first tooth being adapted to engage a first opposing structure of said second of said two portions so that said first tooth restricts at least torsion and/or bending motion of said clamshell housing which results in a separation of said portions of said clamshell housing from each other at the interface at which they meet in a first direction and said second tooth being adapted to engage a second opposing structure of said second of said two portions so that said second tooth restricts at least torsion and/or bending motion of said clamshell housing which results in a separation of said portions of said clamshell housing from each other at the interface at which they meet in a second direction which is opposite to said first direction. The first and second teeth can be small in size so as to resemble posts. The first and second opposing structures can be the same. The opposing structures can be ribs Formed on said second of said two portions.

According to an even further aspect of the present invention, there is provided a portable device having a clamshell housing made of two halves, said halves being controllably separable, wherein said halves are joined together by a method other than having a screw located substantially in each corner of said portable device, comprising: a fastener for coupling each of said two halves of said clamshell housing one to the other to form said clamshell; and at least one torsional and/or bending motion restrictor other than screws or hooks. said at least one torsional and/or bending motion restrictor being arranged so as to reduce the relative motion undergone by the two halves of said clamshell housing at their interface when said clamshell housing is subjected to a torsional and/or bending force with respect to the relative motion that would be undergone by the two halves of said clamshell housing at their interface when said clamshell housing were subjected to the same torsional and/or bending force but in the absence of said at least one torsional and/or bending force restrictor. At least one torsional and/or bending force restrictor can be partly embodied in each of said two halves of said clamshell housing.

According to another aspect of the invention, there is provided a clamshell housing for use in a portable device, said clamshell housing comprising: at least two portions, said portions being controllably separable, a first of said at least two portions having a recess for containing a gasket and a second of said portions having a surface for engaging said gasket in said recess, said surface having at least one pimple projecting therefrom; and a fastening system for providing primary coupling of each of said two at least two portions of said clamshell housing to the other to form a majority of said clamshell, said coupling system employing a coupling method other than having a screw located substantially at each of a majority of any corners of said clamshell housing; such that when said fastening system is engaged, a friction force is developed with respect to said gasket which tends to reduce relative motion of said two at least two portions of said clamshell housing when said housing is subjected to bending and/or torsional force. The recess for containing said gasket can include at least one dimple that corresponds in size substantially to said at least one pimple.

### Brief Description of the Drawing

In the drawing:
FIG. 1 shows exemplary clamshell housing 101 embodying the principles of the invention;
FIG. 2 shows the same housing as in FIG. 1 but where the halves of the clamshell are coupled together;
FIG. 3 shows the same housing as in FIG. 1 but where the teeth and recesses are limited to only a portion of each half of the clamshell;
FIGs. 4, 5, 6 shows various types of teeth and recesses that can employed in accordance with aspects of the invention;
FIG. 7 shows the same tooth structure as in FIG. 5 except that the surface of clamshell half which includes the tooth now has molded therein a step and the surface of the opposing clamshell half has molded therein a mating step;
FIG. 8 shows a tooth engaged in a recess, in accordance with an aspect of the invention;
FIG. 9 shows a post which is the result of shrinking a tooth in size;
FIGs. 10-12 show various teeth and recesses for use with double wall designs, in accordance with aspects of the invention;
FIGs. 13-15 show double-wall-like designs, in accordance with aspects of the invention; and
FIGs. 16-19 show housing designs using teeth and recesses in accordance with the invention that also have the additional advantage of providing an interlocking force normal to the clamshell interface.

### Detailed Description

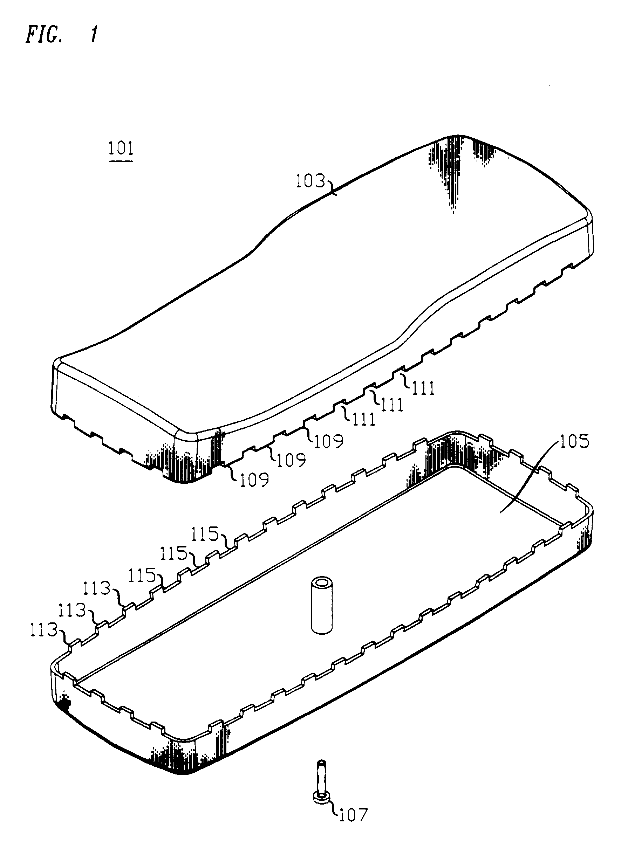

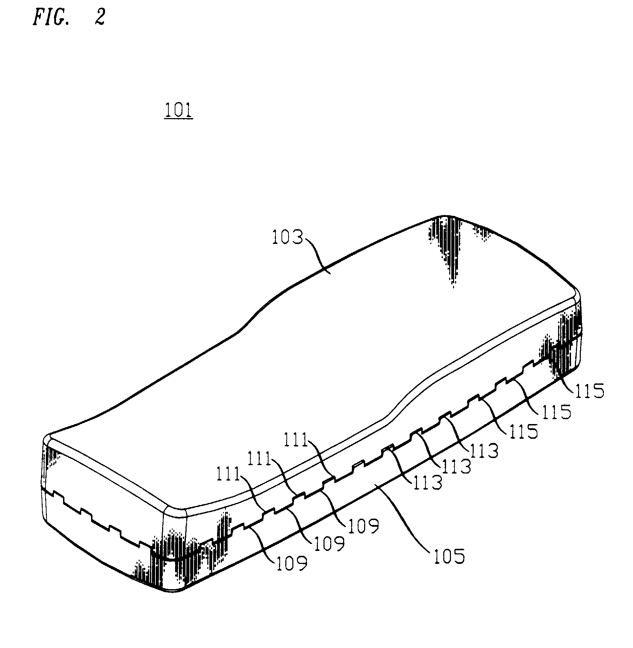

FIG. 1 shows exemplary clamshell housing 101 embodying the principles of the invention. FIG. 1 shows clamshell housing 101 with the halves of the clamshell separated while FIG. 2 shows clamshell housing 101 with the halves of the clamshell mated together. Housing 101 is made up of upper housing 103 and lower housing 105. Screw 107 is used to keep upper housing 103 and lower housing 105 coupled one to the other to form the clamshell. The placement of screw 107 is best if it is in the middle of the surfaces of housing 101 to which it is perpendicular. Molded into upper housing 103 are upper teeth 109 and upper teeth recesses 111. Similarly, molded into lower housing 105 are lower teeth 113 and lower teeth recesses 115. The pattern of teeth on upper housing 103 and lower housing 105 are complementary, so that when upper housing 103 and lower housing 105 are coupled one to the other the teeth of each fit into the recesses of the other. This can be seen in FIG. 2. Advantageously, when moments, e.g., torsional or bending forces, are applied to clamshell housing 101, upper housing 103 and lower housing 105 are prevented from having substantial relative motion between them, which increases the bending and torsional rigidity of clamshell housing 101.

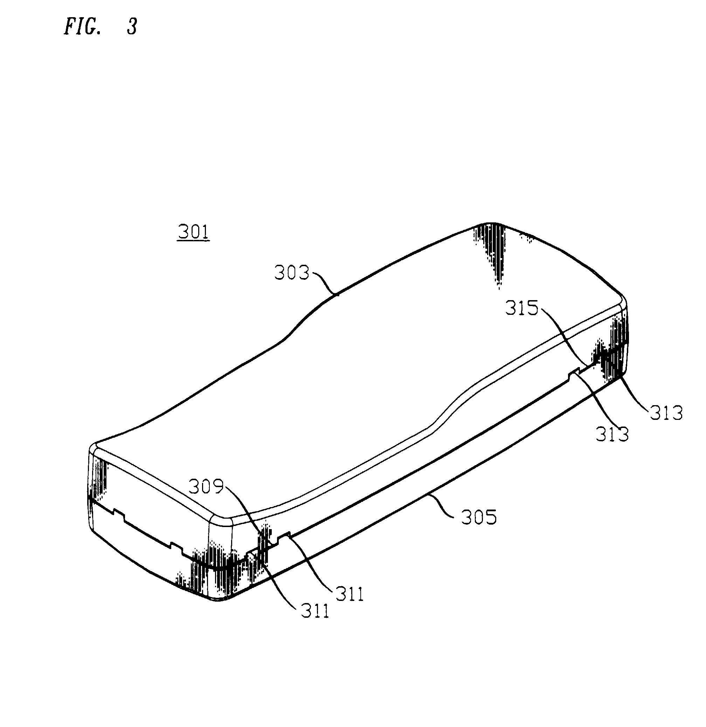

While in FIGs. 1 and 2 the teeth and recesses are shown all the way around each of upper housing 103 and lower housing 105, this is not necessarily required. Doing so is advantageous because it permits the teeth and recesses to be shallower. However, it is possible to place the teeth and recesses along only a portion of each clamshell side. FIG. 3 shows housing 301 which is so arranged. If the teeth and recesses are placed along only a portion of each clamshell side, it is recommended that the teeth and recesses be deeper than if they were placed along the entirety of each clamshell side. Preferably, if the portion of each clamshell side that is to have teeth and recesses is to be limited, the teeth and recesses should be located at the furthest effective distance from a section of bending or torsional weakness about which maximum bending or torsion is likely to occur, for example, at the furthest effective distance from a center of mass of said portable device. By the furthest effective distance it is meant as far away from the center of mass that is within the housing that is not obstructed by another feature of the housing or a component of any circuitry in the device. Typically, for housings, the furthest effective distance is at the corners of the housing. Such an arrangement can clearly be seen in FIG. 3. Additionally, teeth and recesses should be located at the section of bending or torsional weakness.

The dimensions of the teeth that are employed are also a function of the mass, and strength of the torsional or bending force that it is necessary to withstand. Mass is typically reflected in the weight of the device, while the strength of the torsional or bending force are typically determined by the height from which the device is dropped. Note that other factors which contribute to the torsional or bending force experienced by the device when dropped are a) the rigidity of the housing structure, b) the material that the housing is made of, c) the surface onto which the housing is dropped, d) the orientation of the housing at impact, e) the shape of the housing, and f) the size of the housing.

It is not required that the teeth be as shown in FIGs. 1-3. Moreover, it is not required that the teeth be visible externally from the clamshell. Indeed, presently, it is preferable from an aesthetic point of view that the teeth not be visible externally from the clamshell. Also, when the sides of the clamshell are angled to the vertical, it may not be possible to have effective interlocking teeth that are visible externally. Therefore, in accordance with an aspect of the invention, the interlocking teeth are arranged to be internal to the exterior visible surfaces of the clamshell. It is also not necessary that both the teeth and the recesses to receive the teeth be built into each half of the clamshell, nor do they need to be arranged in an alternating manner as shown in FIGs. 1-3.

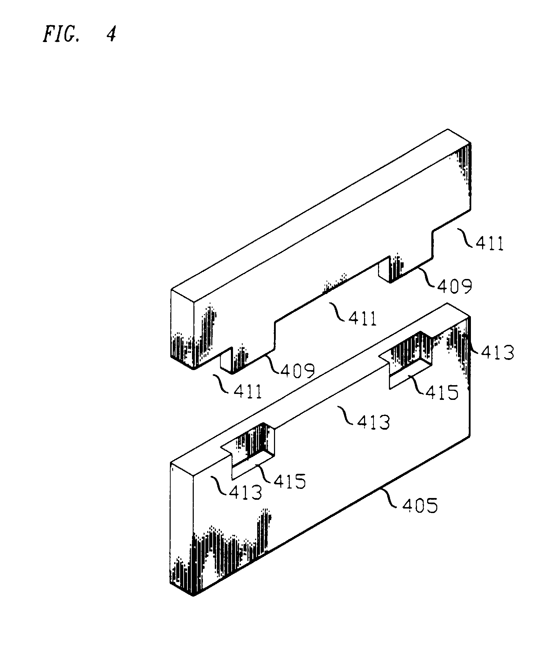

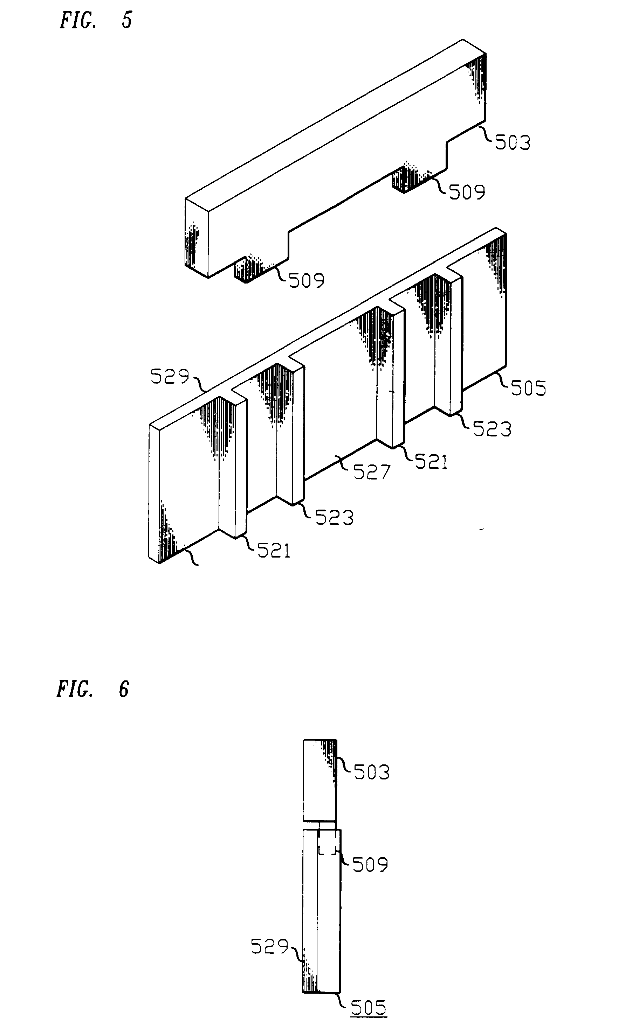

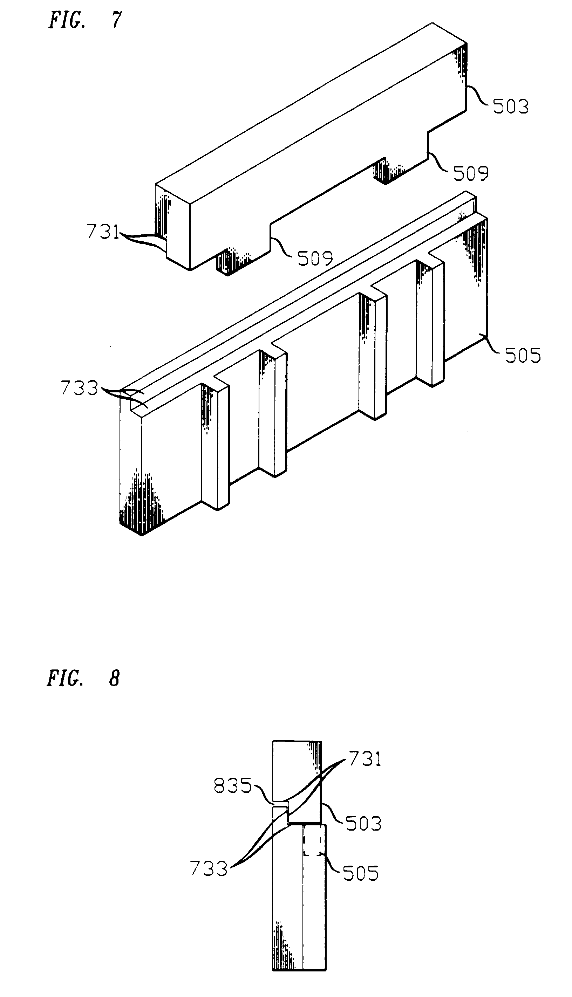

In addition, other shapes and structures may be used as the interlocking "teeth". Moreover, the types of teeth may be mixed and matched, depending on the other design constraints. FIGs. 4, 5, and 6 show various types of teeth and recesses that can be employed. FIG. 4 shows teeth and recesses similar to those of FIGs. 1-3 but the teeth and recesses are arranged to be internal to the clamshell so they are not visible externally thereto. FIG. 5 shows internal tooth 509 that mates into a recess formed by two ribs 521, 523 which protrude from interior side 527 of one of the clamshell halves. Internal tooth 509 is invisible from exterior side 529 of the clamshell half when the clamshell halves are engaged. FIG. 6 shows the tooth engaged in the recess, in accordance with an aspect of the invention.

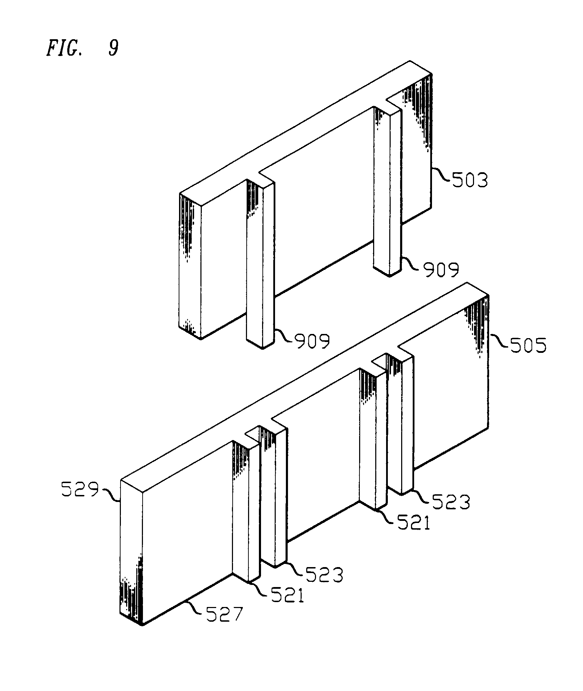

FIG. 7 shows the same tooth structure as in FIG. 5 except that the surface of clamshell half 503 which includes tooth 509 now has molded therein step 731 and the surface of opposing clamshell half 505 has molded therein step 733. The purpose of steps 731 and 733 is to prevent a see-through air gap between the halves of the clamshell. Thus, even though a gap, such as gap 835, may exist between the halves of the clamshell, one cannot see through the gap because of the molded steps. Those of ordinary skill in the art will recognize that such steps may be incorporated into housings with various ones of the tooth and recess arrangements. FIG. 8 shows the tooth engaged in the recess, in accordance with an aspect of the invention. In FIG. 9, post 909 is the result of shrinking tooth 509 (FIG. 5) in size to the size of a post, also known as a rib. Note that post 909 is similar to ribs 521 and 523.

Note that for certain applications it may not be necessary to restrict relative motion between the two halves of the clamshell along both directions of each axis in the plane of the interface of the clamshell halves. Therefore, depending on placement of the tooth and corresponding recess formed by the ribs only one rib may be necessary. Furthermore, each tooth need not necessarily restrict the motion in multiple directions of each axis in the plane of the interface of the clamshell halves. Instead, a first tooth and matching recess may be used to restrict motion in a first direction and a second tooth and matching recess may be used to restrict motion in another direction, etc., until all required directions of motion are constrained.

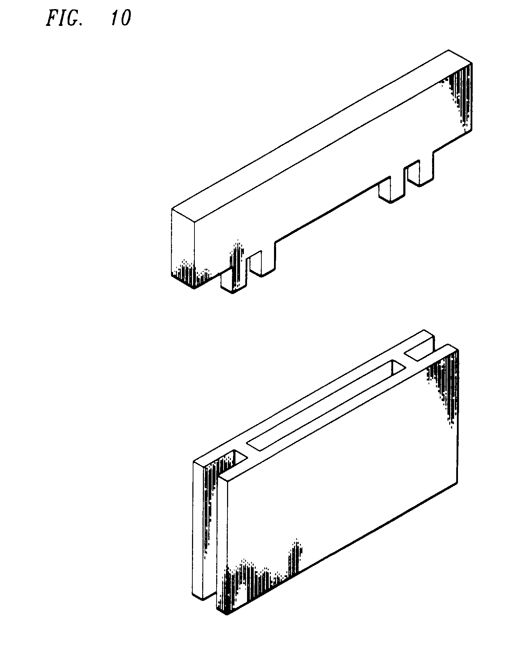

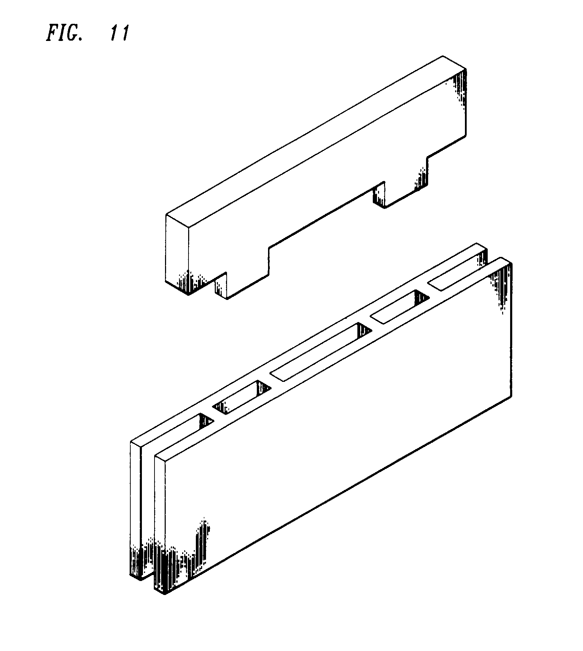

FIGs. 10-12 show various teeth and recesses for use with double wall designs, in accordance with an aspect of the invention. Double wall designs are useful because they add rigidity to the housing while requiring less mass than simply increasing the thickness of a single wall. Such designs are shown in FIGs. 10 and 11. Double wall designs may also be useful when a sealing gasket is employed at the interface between the clamshell halves. Such a sealing gasket may be employed to reduce electromagnetic interference (EMI) or radio frequency interference (RFI).

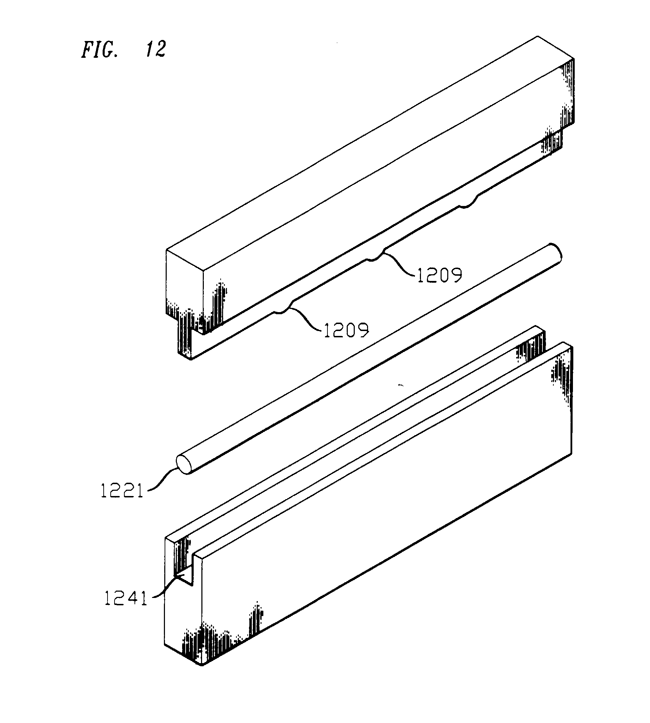

FIG. 12 shows an arrangement for a clamshell housing employing high friction elastomeric gasket 1221 for restriction motion, in accordance with an aspect of the invention. In FIG. 12, pimple 1209 is the result of shrinking tooth 509 (FIG. 5) in size to the size of a bump. Gasket 1221 is squeezed between pimple 1209 and mating surface recess 1241 to provide very high friction between the surfaces. Also preferably, such pimples are replicated around the interface between the clamshell halves. It may also be desired to include dimples (not shown) in recess 1215, which results when recess 515 is shrunk in size so as to be, essentially, a mate for pimple 1209.

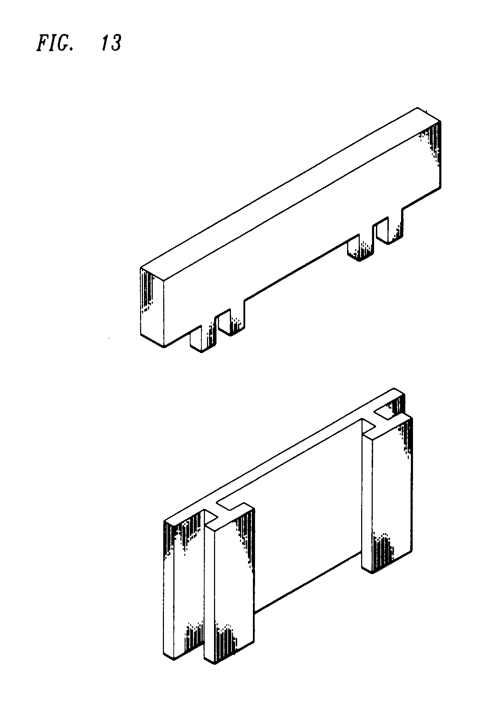

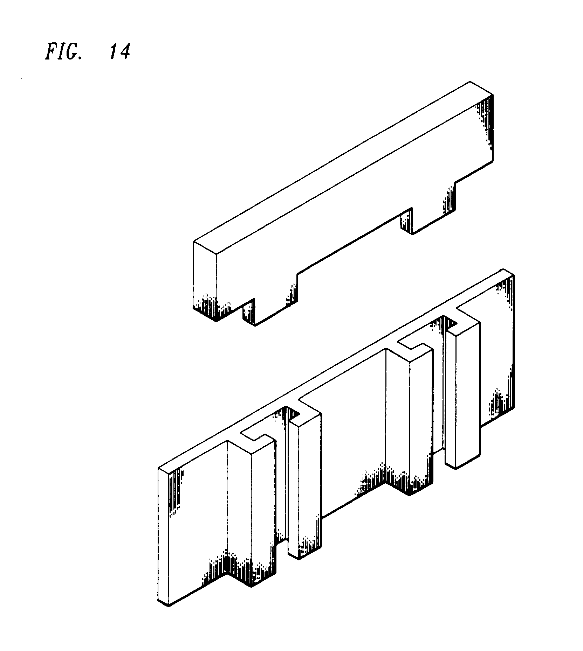

Double wall designs, and double-wall-like, can restrict motion along an additional axis, possibly alleviating the need to have teeth and recesses along a different side of the clamshell. Such restriction occurs with the double wall designs of FIGs. 10-12. In addition, FIGs. 13-15 show double-wall-like designs which provide the same effect.

The gaps between the teeth and recesses are preferably small with respect to the dimensions of the mating features. For example, for use in hand-held telephones, a gap of 0.1 to 0.2 mm has been found to be useful.

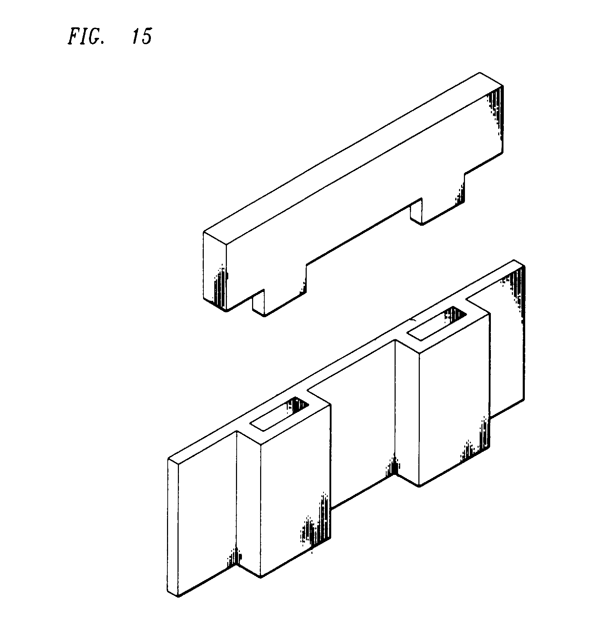

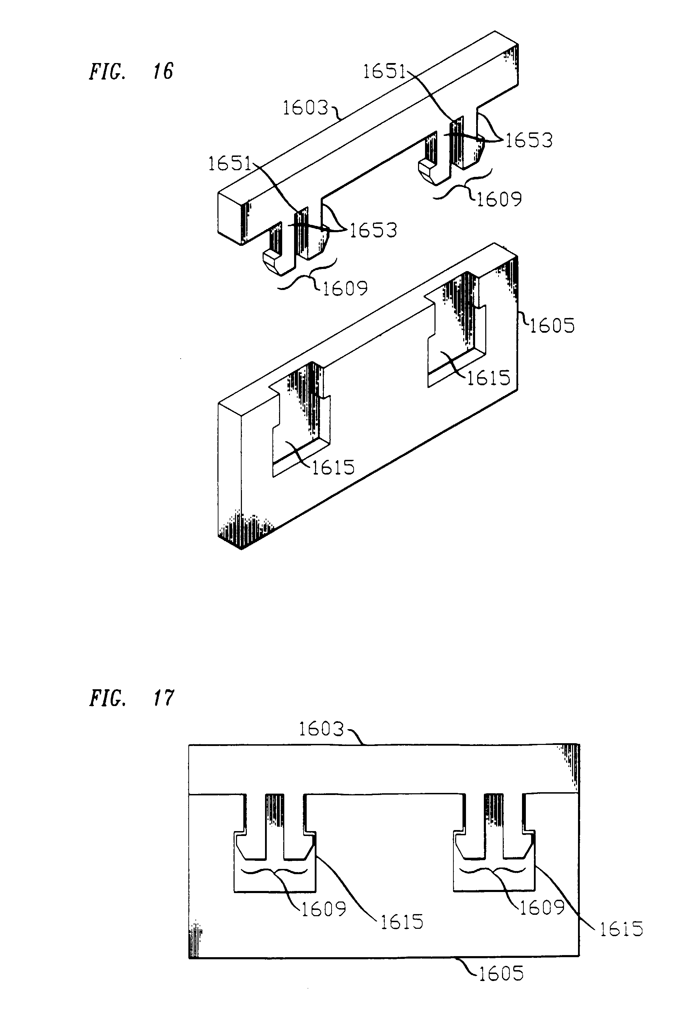

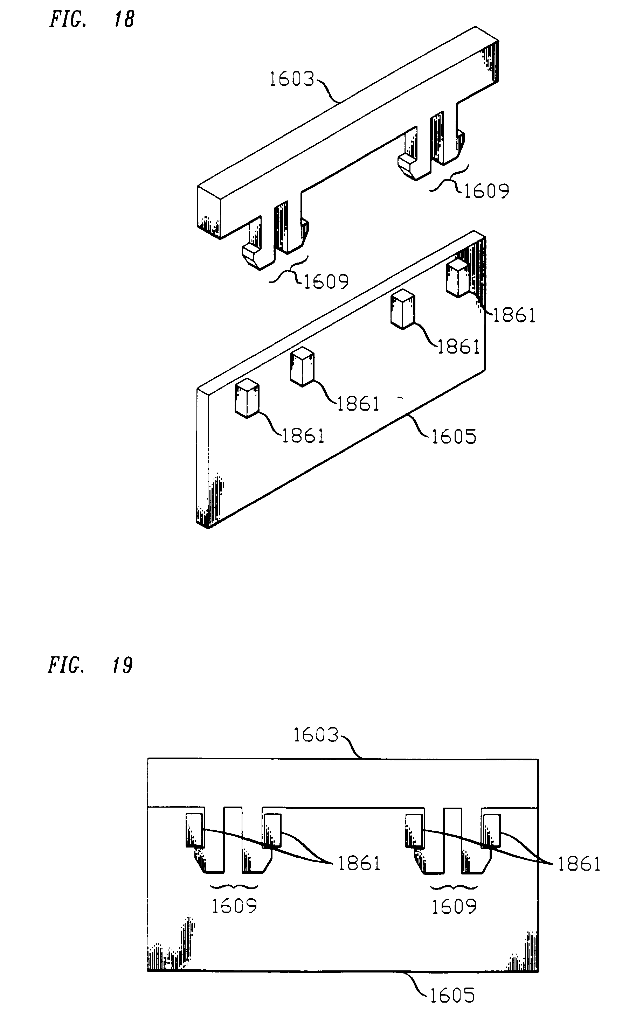

FIGs. 16-19 show housing designs using teeth and recesses in accordance with the invention that also have the additional advantage of providing an interlocking force normal to the clamshell interface. More specifically, tooth 1609 is formed as a snap which engages with recess 1615. Gap 1651 permits halves of snap 1609 to move toward each other when it is inserted into, or removed from, recess 1615 to permit engaging and disengaging of clamshell halves 1603 and 1605. FIG. 17 shows clamshell halves 1603 and 1605 engaged with snap 1609 inserted into recess 1615. FIG. 18 shows an embodiment of the invention similar to that shown in FIG. 16, except that recesses 1615 are replaced by a gap between posts 1861. Posts have the advantage of permitting the walls of the clamshell to be thinner overall. FIG. 19 shows an engaged view of the clamshell halves 1603 and 1605 engaged with snap 1609 inserted in the gap between posts 1861.

One advantage of the invention is that it significantly improves the performance of the clamshell housing in drop tests over similar clamshell housings of essentially the same design but that do not embody the invention. In particular, when a portable device having a housing designed in accordance with the principles of the invention is dropped, the tendency to have substantial relative motion, i.e., slip, between the two halves of a clamshell type housing along the interface where they meet, is reduced. As a result, the likelihood that the housing, or a portion thereof, will pop open so as to cause gaps at the interface, is concomitantly reduced. This is true because the resulting bending and/or torsional rigidity of the housing is increased by implementation of the invention.

Note that by torsion and/or bending it is meant individually a) torsion separately, b) bending separately, or c) bending and torsion in combination. When mentioned in connection with a force there is no implication that both bending and torsional forces must be present, any one will suffice, although both may be present. Likewise, when mentioned in connection with engaging elements or motion restricting elements, such elements need only restrict one or the other of bending or torsional motion, although they may restrict both.

The foregoing merely illustrates the principles of the invention. It will thus be appreciated that those skilled in the art will be able to devise various arrangements which, although not explicitly described or shown herein, embody the principles of the invention and are thus within its scope.

## Claims

1. A portable device having a clamshell housing made of two halves, said halves meeting at an interface and being controllably separable, said device comprising:
a single fastener (107) for coupling said two halves one to the other to form said clamshell;
a plurality of engaging elements, said engaging elements being positioned at said interface along at least a portion of each clamshell side and each comprising an item from the set consisting of:
(i) a tooth (109, 409, 509) added to one of said halves and a matching recess (111, 415) added to the other of said halves,
(ii) a snap (1609) added to one of said halves which engages a receptacle (1615) added to the other of said halves,
(iii) a post (909) added to one of said halves and matching receptacle (521, 523) added to the other of said halves, and
(iv) a pimple (1209) projecting from a surface of one of said halves which engages a gasket (1221) contained in a recess (1241) in the other of said halves;
wherein said engaging elements are oriented so that when engaged they prevent said two halves of said clamshell housing from having substantial relative motion between themselves along said interface when said device is subjected to bending and/or torsional moments.

2. The device as defined in claim I wherein said fastener includes a screw (107).

3. The device as defined in claim 1 wherein said engaging elements are located at a furthest effective distance from a center of mass of said portable device.

4. The device as defined in claim 1 wherein said interface is externally visible.

5. The device as defined in claim 1 wherein at least a portion of opposite facing sides of said clamshell halves rest on top of each other.

6. The device as defined in claim 1 wherein said clamshell housing has a well defined section of bending and/or torsional weakness about which maximum bending and/or torsion is likely to occur and said elements are located at a furthest effective distance from said section of bending and/or torsional weakness.

7. The device as defined in claim 1 wherein said clamshell housing has a well defined section of bending and/or torsional weakness about which maximum bending and/or torsion is likely to occur and said engaging elements are located as close as possible to said section of bending and/or torsional weakness given said clamshell housing and contents contained therein.

## Patentansprüche

1. Tragbare Vorrichtung mit einem aus zwei Hälften bestehenden Schalengehäuse, wobei die Hälften an einer Grenzfläche aufeinandertreffen und steuerbar getrennt werden können, mit folgendem:
einem einzelnen Befestigungselement (107) zur Verbindung der beiden Hälften miteinander zur Bildung der Schale;
mehreren Eingriffselementen, die entlang mindestens einem Teil jeder Schalenseite an der Grenzfläche angeordnet sind und jeweils ein Element des aus folgendem bestehenden Satzes enthalten:
(i) einem Zahn (109, 409, 509), der an einer der Hälften angefügt ist, und einer damit zusammenpassenden Aussparung (111, 415), die in der anderen der Hälften ausgebildet ist,
(ii) einer Schnappvorrichtung (1609), die an einer der Hälften angefügt ist und eine an der anderen der Hälften ausgebildete Aufnahme (1615) in Eingriff nimmt,
(iii) einem Steg (909), der an einer der Hälften angefügt ist, und einer damit zusammenpassenden Aufnahme (521, 523), die an der anderen der Hälften ausgebildet ist, und
(iv) einem Nocken (1209), der von einer Fläche einer der Hälften vorragt und eine in einer Aussparung (1241) in der anderen der Hälften enthaltene Dichtung (1221) in Eingriff nimmt;
wobei die Eingriffselemente so ausgerichtet sind, daß sie im Eingriffszustand verhindern, daß die beiden Hälften des Schalengehäuses eine im wesentlichen relative Bewegung zwischen sich entlang der Grenzfläche ausführen können, wenn die Vorrichtung Biege- und/oder Torsionsmomenten ausgesetzt wird.

2. Vorrichtung nach Anspruch 1, bei der das Befestigungselement eine Schraube (107) umfaßt.

3. Vorrichtung nach Anspruch 1, bei der die Eingriffselemente in einem am weitesten entfernten, effektiven Abstand von einem Massenmittelpunkt der tragbaren Vorrichtung angeordnet sind.

4. Vorrichtung nach Anspruch 1, bei der die Grenzfläche von außen aus sichtbar ist.

5. Vorrichtung nach Anspruch 1, bei der die einander gegenüberliegenden Seiten der Schalenhälften mindestens teilweise aufeinander ruhen.

6. Vorrichtung nach Anspruch 1, bei der das Schalengehäuse einen wohldefinierten biege- und/oder torsionsweichen Abschnitt aufweist, um den maximale Biegung und/oder Torsion höchstwahrscheinlich auftritt, und die Elemente in einem am weitesten entfernten, effektiven Abstand von dem biege- und/oder torsionsweichen Abschnitt angeordnet sind.

7. Vorrichtung nach Anspruch 1, bei der das Schalengehäuse einen wohldefinierten biege- und/oder torsionsweichen Abschnitt aufweist, um den maximale Biegung und/oder Torsion höchstwahrscheinlich auftritt, und die Eingriffselemente unter Berücksichtigung des gegebenen Schalengehäuses und seines Inhalts so nahe wie möglich an dem biege- und/oder torsionsweichen Abschnitt angeordnet sind.

## Revendications

1. Dispositif portatif doté d'un boîtier formant une coque constitué de deux moitiés, lesdites moitiés se joignant au niveau d'une interface et étant séparables de façon contrôlable, ledit dispositif comprenant :
une attache unique (107) servant à coupler lesdites deux moitiés l'une à l'autre pour former ladite coque ;
une pluralité d'éléments d'enclenchement, lesdits éléments d'enclenchement étant positionnés au niveau de ladite interface le long d'au moins une partie de chaque côté de la coque et chacun comprenant un article parmi le groupe comprenant :
(i) une dent (109, 409, 509) ajoutée à l'une desdites moitiés et un évidement correspondant (111, 415) ajouté à l'autre desdites moitiés,
(ii) un encliquetage (1609) ajouté à l'une desdites moitiés, qui s'enclenche avec un réceptacle (1615) ajouté à l'autre desdites moitiés,
(iii) une colonnette (909) ajoutée à l'une desdites moitiés et un réceptacle correspondant (1615) ajouté à l'autre desdites moitiés, et
(iv) une bossette (1209) faisant saillie depuis une surface d'une desdites moitiés et s'enclenchant avec un joint d'étanchéité (1221) contenu dans un évidement (1241) dans l'autre desdites moitiés ;
dans lequel lesdits éléments d'enclenchement sont orientés de façon à empêcher, une fois enclenchés, le mouvement relatif substantiel desdites deux moitiés dudit boîtier formant une coque, le long de ladite interface lorsque ledit dispositif est soumis à des moments de flexion et/ou de torsion.

2. Dispositif selon la revendication 1, dans lequel ladite attache comporte une vis (107).

3. Dispositif selon la revendication 1, dans lequel lesdits éléments d'enclenchement sont situés à une distance effective la plus éloignée possible d'un centre de masse dudit dispositif portatif.

4. Dispositif selon la revendication 1, dans lequel ladite interface est visible de l'extérieur.

5. Dispositif selon la revendication 1, dans lequel au moins des parties respectives des côtés en regard desdites moitiés de la coque reposent l'une sur l'autre.

6. Dispositif selon la revendication 1, dans lequel ledit boîtier formant une coque comporte une section bien définie présentant une certaine faiblesse en flexion et/ou torsion au niveau de laquelle une flexion et/ou torsion maximale a des chances de se produire, et lesdits éléments sont situés à une distance effective la plus éloignée possible de ladite section de faiblesse en flexion et/ou torsion.

7. Dispositif selon la revendication 1, dans lequel ledit boîtier formant une coque comporte une section bien définie présentant une certaine faiblesse en flexion et/ou torsion au niveau de laquelle une flexion et/ou torsion maximale a des chances de se produire, et lesdits éléments d'enclenchement sont situés aussi près que possible de ladite section de faiblesse en flexion et/ou torsion si l'on considère ledit boîtier formant une coque et son contenu.
